# EUROPEAN PATENT APPLICATION

(11) **EP 4 231 097 A1**
(43) Date of publication of application: **23.08.2023**
(21) Application number: 22157906.3
(22) Date of filing: 22.02.2022
(51) Int. Cl.: G03F 7/20, G01N 21/15, G01N 21/956

(54) **INSPECTION TOOL AND BARRIER FOR USE THEREIN**

(71) Applicant: ASML Netherlands B.V., 5500 AH Veldhoven (NL)
(72) Inventor: KLEIN, Alexander, Ludwig, 5500 AH Veldhoven (NL); VAN DER WOORD, Ties, Wouter, 5500 AH Veldhoven (NL)
(74) Representative: ASML Netherlands B.V.

(57) **Abstract**

A sample inspection tool is described. The inspection tool includes a light source configured to produce effective inspection radiation below 200nm, a sample holder, an imaging sub-system containing sub-system components that delivers light along an optical path from the light source to a sample to be held by the sample holder, and a barrier positioned between the last sub-system component in the optical path and the sample to be held by the sample holder. The barrier permits the radiation to pass therethrough while inhibiting impurities from reaching the sample to be held by the sample holder. In another embodiment, a barrier is provided for use in an inspection tool.

## Description

### TECHNICAL FIELD

The present invention generally relates to inspection tools and barriers capable of inhibiting impurities therein.

### BACKGROUND

As the demand for integrated circuits having ever-small device features continues to increase, the need for inspection of these ever-shrinking devices continues to grow. During inspection, samples (e.g., wafers) are checked to determine if they contain defects. Impurities generated during the inspection process can have deleterious effects on the inner workings and/or components of the inspection tool, leading to erroneous inspection results. In addition, such impurities can potentially adversely impact the sample itself if the impurities reach the sample. A reduction of impurities at various locations is desired.

### SUMMARY

In one embodiment, the present disclosure is directed to a sample inspection tool. The inspection tool comprises a light source configured to produce effective inspection radiation below a wavelength of 200nm; a sample holder; and an imaging sub-system containing sub-system components that delivers light along an optical path from the light source to a sample to be held by the sample holder. A barrier is positioned between the last sub-system component in the optical path and the sample to be held by the sample holder, the barrier permitting the radiation to pass therethrough while inhibiting impurities from reaching the sample to be held by the sample holder.

In one embodiment the impurities comprise particulates, spectral impurities, and/or include a particular gas or gasses in the inspection tool.

In one embodiment, the barrier comprises a thin film having multiple layers, wherein a first layer is made of a first material or composition of materials and a second layer is made of a second material or composition of materials.

In one embodiment, the barrier comprises a thin film of carbon-containing material or a thin film of silicon-containing material.

In one embodiment, the barrier comprises a frame surrounding a thin film, wherein the thin film has a thickness between 3nm and 200nm.

In one embodiment, a releasable barrier holder is configured to hold the barrier at the position between the last optical element in the optical path and the sample to be held by the sample holder, the barrier holder configured to release the barrier to permit replacement thereof.

In one embodiment, the light source is configured to produce the effective inspection radiation of greater than 100nm.

In one embodiment, the barrier is separated from the sample by 0.1mm to 10mm

In another embodiment, the sample inspection tool comprises a light source configured to produce effective inspection radiation below 200nm; a sample holder; an imaging sub-system comprising sub-system components) that delivers light along an optical path from the light source to a sample to be held by the sample holder; and a barrier positioned in the optical path prior to the last sub-system component within the optical path, the barrier inhibiting impurities from reaching at least one sub-system component within the optical path, wherein the impurities comprise particulates.

In another embodiment, a sample inspection tool comprises a light source configured to produce effective inspection radiation below 200nm; a sample holder; an imaging sub-system containing sub-system components that that delivers light along an optical path from the light source to a sample to be held by the sample holder; a plurality of barriers positioned within the optical path, the plurality of barriers inhibiting impurities from reaching the sub-system components and the sample to be held by the sample holder.

In one embodiment, the plurality of releasable barrier holders is configured to hold the plurality of barriers positioned within the optical path, the barrier holders configured to release the barriers to permit replacement thereof.

In yet another embodiment, the present disclosure is directed to a barrier for use in an inspection tool. The barrier comprises a thin film having multiple layers, wherein a first layer is made of a first material or composition of materials and a second layer is made of a second material or composition of materials, different from the first material; wherein the thin film comprises a carbon containing material and having a thickness between 3nm and 200nm; wherein the barrier comprises a frame surrounding the thin film, and wherein the barrier allows radiation to pass therethrough and inhibits impurities from passing therethrough.

In another embodiment, the first layer inhibits particulate impurities from passing therethrough and the second layer inhibits spectral impurities from passing therethrough.

It is to be understood that both the foregoing general description and the following detailed description are exemplary and explanatory only and are not necessarily restrictive of the present disclosure. The accompanying drawings, which are incorporated in and constitute a part of the characteristic, illustrate subject matter of the disclosure. Together, the descriptions and the drawings serve to explain the principles of the disclosure.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
FIG. 1A is a conceptual view of a system for imaging a sample with a barrier attached to the sample, in accordance with one embodiment of the present invention.
FIG. 1B is a bottom view of the FIG. 1A system showing the barrier and sample.
FIG. 1C is a side view of the FIG. 1A system showing the barrier and sample.
FIG. 2A is a conceptual view of a system for imaging a sample with a barrier attached below the last optical element, in accordance with one embodiment of the present invention.
FIG. 2B is a top view of the FIG. 2A system showing the barrier and sample.
FIG. 2C is a side view of the FIG. 2A system showing the barrier and sample.
FIG. 3 is a conceptual view of a system for imaging a sample with a barrier positioned in the optical path prior to the last optical element, in accordance with one embodiment of the present invention.
FIG. 4 is a conceptual view of a system for imaging a sample with a plurality of barriers positioned in the optical path, in accordance with one embodiment of the present invention.
FIG. 5A is a schematic view of a side view of a barrier showing the multilayer thin film and frame.
FIG. 5B is a schematic view of a top view of a barrier showing the multilayer thin film and frame.

### DETAILED DESCRIPTION

Reference will now be made in detail to the subject matter disclosed, which is illustrated in the accompanying drawings.

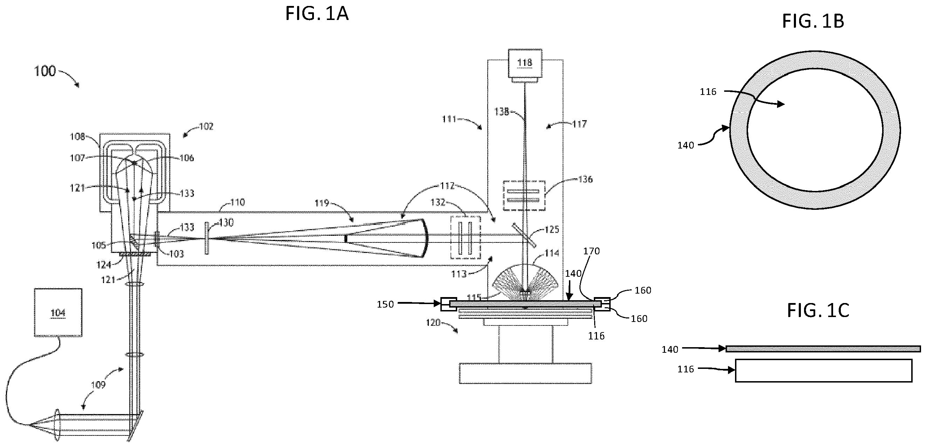

Referring generally to FIGS. 1 through 5, a sample inspection tool for inspecting a sample with illumination is described in accordance with the present disclosure. Embodiments of the present disclosure are directed to the optical inspection of samples using short wavelength illumination, such as VUV radiation, generated with a laser sustained plasma light source. Embodiments of the present disclosure are directed to the coupling of the short wavelength optical output of a laser sustained plasma light source with illumination optics of a corresponding imaging sub-system (e.g., inspection sub-system, metrology sub-system and the like).

FIG. 1A illustrates an inspection tool or system (these terms being used interchangeably herein) 100 for imaging a sample with a laser sustained plasma illumination output, in accordance with an embodiment of the present disclosure. In a general sense, the system 100 should be interpreted to extend to any plasma based light source known in the art that generates effective inspection radiation with a wavelength less than 200nm.

The system 100 includes a light source 102. In one embodiment, the light source can be a laser sustained plasma (LSP) illumination sub-system. It is noted herein that the term "light source 102" can be used interchangeably with "LSP illumination sub-system 102" throughout the present disclosure. In one embodiment, the LSP illumination sub-system 102 includes a pump source 104 configured to generate pumping illumination 121 including of one or more first selected wavelengths, such as, but not limited to infrared (IR) radiation, visible light and ultraviolet light. For example, the pump source 104 may include any source capable of emitting illumination in the range of approximately200 nm to 1.5µm. In another embodiment, the LSP illumination sub-system or light source 102 includes a gas containment element 108, such as, but not limited to, a chamber, a plasma cell or a plasma bulb. In one embodiment, the gas containment element 108 of the light source 102 contains a volume of gas used to establish and maintain a plasma 107 in order to generate inspection radiation, as will be described. Specifically, in one embodiment, the LSP illumination sub-system or light source 102 includes a collector 106, or reflector, configured to focus (e.g., via a reflective internal surface) the pumping illumination 121 from the pumping source 104 into the volume of gas contained within the gas containment element 108. In this regard, the collector 106 may generate a plasma 107 within the volume of gas. Further, the plasma 107 of the light source 102 may emit broadband radiation 133 including one or more second selected wavelengths, such as, but not limited to, VUV radiation, DUV radiation, UV radiation or visible light, used for purposes of inspection (inspection radiation). For example, the LSP illumination sub-system 102 may include, but is not limited to, any LSP configuration capable of emitting light (inspection radiation) having a wavelength in the range of 100nm to 200nm. In another embodiment, the light source or LSP illumination subsystem can emit inspection radiation having a wavelength in the range of 120nm to 200nm. By way of another example, the LSP illumination sub-system 102 may include, but is not limited to, any LSP configuration capable of emitting light (inspection radiation) having a wavelength below 100nm. In another embodiment, the collector 106 is arranged to collect the broadband illumination 133 (e.g., VUV radiation, DUV radiation, UV radiation and/or visible light) emitted by plasma 107 and direct the broadband illumination 133 to one or more additional optical elements (e.g., steering optics, beam splitter, collecting aperture, filter, homogenizer and the like). For example, the collector 106 may collect at least one of VUV broadband radiation, DUV broadband radiation, UV broadband radiation or visible light emitted by plasma 107 and direct the broadband illumination 133 to a mirror 105 (e.g., mirror 105 serving to optically couple LSP illumination sub-system 102 to an optical input of the illumination sub-system 112 of the imaging sub-system 111). In this regard, the LSP illumination subsystem 102 may deliver VUV radiation, DUV radiation, UV radiation and/or visible radiation to downstream optical elements of any optical characterization system known in the art, such as, but not limited to, an inspection tool or a metrology tool.

In another embodiment, the system 100 includes a stage assembly or sample holder (these terms being used interchangeably herein) 120 suitable for securing a sample 116. The stage assembly or sample holder 120 may include any sample stage architecture known in the art. For example, the stage assembly 120 may include, but is not limited to, a linear stage. By way of another, the stage assembly 120 may include, but is not limited to, a rotational stage. Further, the sample 116 may include or comprise a wafer, such as, but not limited to, a semiconductor wafer.

In another embodiment, the system 100 includes an imaging sub-system 111. It is noted herein that the imaging sub-system 111 may be coupled to the illumination output of the LSP illumination sub-system 102. In this regard, the imaging sub-system 111 may inspect, or otherwise analyze, one or more samples 116 utilizing the illumination output (e.g., VUV light) from the LSP illumination sub-system 102. It is noted herein that throughout the present disclosure the term "imaging sub-system" is used interchangeably with the term "inspector."

In another embodiment, the imaging sub-system 111 includes an illumination sub-system 112, or an "illuminator." In one embodiment, the illumination sub-system 112 illuminates a surface of the one or more samples 116 with at least a portion of the broadband radiation emitted from the plasma 107 generated by the laser sustained plasma illumination sub-system 102. In on embodiment, the illumination sub-system 112 delivers the broadband radiation 133 to the surface of the sample 116 via an illumination pathway 113. The illumination sub-system 112 may include any number and type of optical elements suitable for delivering broadband radiation 133 from an output of the LPS subsystem 102 to the surface of the sample 116. For example, the illumination sub-system 112 may include one or more lenses 119, one or more filters 130 (e.g., sub-band filter), one or more collimating elements (not shown), one or more polarizing elements (not shown), one or more beam splitters 125 for directing, focusing and otherwise processing broadband radiation 133 emitted by the LSP illumination sub-system 102.

In another embodiment, the imaging sub-system 111 includes an objective 114 and a detector 118. In one embodiment, the objective 114 may collect illumination after it is scattered or reflected from one or more portions of the sample 116 (or particles disposed on the sample 116). Then, the objective may focus the collected illumination via a collection pathway 117 to a detector 118 to form an image of one or more portions of the surface of the sample 116. It is noted herein that the objective 114 may include any objective known in the art suitable for performing inspection (e.g., darkfield inspection or brightfield inspection) or optical metrology. Further, it is noted herein that the detector 118 may include any optical detector known in the art suitable for measuring illumination received from the sample 116. For example, the detector 118 may include, but is not limited to, a CCD detector, a TDI detector or the like.

In another embodiment, the system 100 includes a purged chamber 110. In one embodiment, the purged chamber 110 contains, or is suitable for containing, a selected purge gas. In one embodiment, the purged chamber 110 contains the illumination sub-system 113, the objective 114 and/or the detector 118. In another embodiment, the purged chamber 110 purges the illumination pathway 113 and/or the collection pathway 117 with a selected purge gas. It is noted herein that the use of a purged chamber 110 allows the collected plasma-generated broadband light 133, such as VUV light, to be transmitted through the illumination optics of the illumination sub-system 112 with minimal signal degradation, or at least reduced degradation. The use of a purging gas in the purged chamber 110 allows for the utilization of shorter wavelength light, such as VUV light, during inspection and avoids the need for performing pulsed plasma inspection for short wavelength regimes, such as, but not limited to, VUV light (100-200 nm). It is further recognized that such a configuration enables the utilization of a TDI-based sensor in detector 118. The purge gas used in purged chamber 110 may include any purge gas known in the art. For example, the selected purge gas may include, but is not limited to, a noble gas, an inert gas, a non-inert gas or a mixture two or more gases. For instance, the selected purge gas may include, but is not limited to, argon, Xe, Ar, Ne, Kr, He, N₂ and the like. By way of another example, the selected purge gas may include a mixture of argon with an additional gas.

In another embodiment, the system 100 includes a window 103 transparent to at least a portion of the broadband radiation 133. The window 103 serves to optically couple the illumination sub-system 112 with the output of the LSP illumination sub-system 102, while maintaining a separation between the atmosphere of the purge chamber 110 and the atmosphere of the LSP illumination sub-system 102 (and component systems). For example, in the case of VUV broadband radiation emitted from the plasma 107, the window 103 may include a material transparent to VUV radiation. For instance, a VUV-suitable window may include, but is not limited to, CaF₂ or MgF₂.

It is recognized herein that the gas containment element 108 may include a number of gascontaining structures suitable for initiating and/or maintaining a plasma 107. In one embodiment, the gas containment element 108 may include, but is not limited to, a chamber, a plasma cell or a plasma bulb.

In some embodiments, the transmitting portion of the gas containment element 108 (e.g., chamber, cell or bulb) may be formed from any material known in the art that is at least partially transparent to radiation 133 generated by plasma 107 and/or the pump illumination 121. In one embodiment, the transmitting portion of the gas containment element 108 may be formed from any material known in the art that is at least partially transparent to VUV radiation, DUV radiation, UV radiation and/or visible light generated by plasma 107. In another embodiment, the transmitting portion of the gas containment element 108 may be formed from any material known in the art that is at least partially transparent to IR radiation, visible light and/or UV light from the pump source 104.

In some embodiments, the transmitting portion of the gas containment structure may be formed from a low-OH content fused silica glass material. In other embodiments, the transmitting portion of the plasma cell 101 may be formed from high-OH content fused silica glass material. For example, the transmission element or bulb of the plasma cell 101 may include, but is not limited to, SUPRASIL 1, SUPRASIL 2, SUPRASIL 300, SUPRASIL 310, HERALUX PLUS, HERALUX-VUV, and the like. In other embodiments, the transmission element or bulb of the plasma cell 101 may include, but is not limited to, CaF₂, MgF₂, crystalline quartz and sapphire. It is again noted herein that materials such as, but not limited to, CaF₂, MgF₂, crystalline quartz and sapphire provide transparency to short-wavelength radiation (e.g., λ<190 nm). Various glasses suitable for implementation in the gas containment element 108 (e.g., chamber window, glass bulb or transmission element/window of plasma cell) of the present disclosure are discussed in detail in A. Schreiber et al., Radiation Resistance of Quartz Glass for VUV Discharge Lamps, J. Phys. D: Appl. Phys. 38 (2005), 3242-3250, which is incorporated herein by reference in the entirety.

In one embodiment, the gas containment element 108 may contain any selected gas (e.g., argon, xenon, mercury, or the like) known in the art suitable for generating a plasma upon absorption of pump illumination 104. In one embodiment, focusing illumination 121 from the pump source 104 into the volume of gas causes energy to be absorbed by the gas or plasma (e.g., through one or more selected absorption lines) within the plasma cell 107, thereby "pumping" the gas species in order to generate and/or sustain a plasma. In another embodiment, although not shown, the gas containment structure 108 may include a set of electrodes for initiating the plasma 107 within the internal volume of the gas containment structure 108, whereby the illumination from the pump source 104 maintains the plasma 107 after ignition by the electrodes.

It is contemplated herein that the system 100 may be utilized to initiate and/or sustain a plasma 107 in a variety of gas environments. In one embodiment, the gas used to initiate and/or maintain plasma 107 may include a noble gas, an inert gas (e.g., noble gas or non-noble gas) or a non-inert gas (e.g., mercury). In another embodiment, the gas used to initiate and/or maintain a plasma 107 may include a mixture of two or more gases (e.g., mixture of inert gases, mixture of inert gas with non-inert gas or a mixture of non-inert gases). In another embodiment, the gas may include a mixture of a noble gas and one or more trace materials (e.g., metal halides, transition metals and the like).

By way of example, the volume of gas used to generate a plasma 107 may include argon. For instance, the gas may include a substantially pure argon gas held at pressure in excess of 5atm (e.g., 20-50atm). In another instance, the gas may include a substantially pure krypton gas held at pressure in excess of 5atm (e.g., 20-50atm). In another instance, the gas may include a mixture of argon gas with an additional gas.

It is further noted that the present invention may be extended to a number of gases. For example, gases suitable for implementation in the present invention may include, but are not limited, to Xe, Ar, Ne, Kr, He, N₂, H₂O, O₂, H₂, D₂, F₂, CH₄, one or more metal halides, a halogen, Hg, Cd, Zn, Sn, Ga, Fe, Li, Na, Ar:Xe, ArHg, KrHg, XeHg, and the like. In a general sense, the present invention should be interpreted to extend to any light pumped plasma generating system and should further be interpreted to extend to any type of gas suitable for sustaining a plasma within a gas containment structure, such as a gas chamber, a plasma cell or a plasma bulb.

The collector 106 may take on any physical configuration known in the art suitable for focusing illumination emanating from the pump source 104 into the volume of gas contained within the gas containment element 108. In one embodiment, the collector 106 may include a concave region with a reflective internal surface suitable for receiving illumination 121 from the pump source 104 and focusing the illumination into the volume of gas contained within the gas containment element 108. For example, the collector 106 may include an ellipsoid-shaped collector 106 having a reflective internal surface.

It is noted herein that LSP illumination sub-system 102 may include any number and type of additional optical elements. In one embodiment, the set of additional optics may include collection optics configured to collect broadband light emanating from the plasma 107. For instance, the LSP illumination sub-system 102 may include one or more additional optical elements arranged to direct illumination from the collector 106 to downstream optics. In another embodiment, the set of optics may include one or more lenses placed along either the illumination pathway or the collection pathway of the LSP illumination sub-system 102. The one or more lenses may be utilized to focus illumination from the pump source 104 into the volume of gas within the gas containment element 108. Alternatively, the one or more additional lenses may be utilized to focus broadband light emanating from the plasma 107 to a selected target or a focal point (e.g., focal point within illumination sub-system 112).

In another embodiment, the set of optics may include one or more filters placed along either the illumination pathway or the collection pathway of the LSP illumination sub-system 102 in order to filter illumination prior to light entering the gas containment element 108 or to filter illumination following emission of the light from the plasma 107. It is noted herein that the set of optics of the LSP illumination sub-system 102 as described herein are provided merely for illustration and should not be interpreted as limiting. It is anticipated that a number of equivalent or additional optical configurations may be utilized within the scope of the present invention.

In another embodiment, the pump source 104 of system 100 may include one or more lasers. In a general sense, pump source 104 may include any laser system known in the art. For instance, the pump source 104 may include any laser system known in the art capable of emitting radiation in the infrared, visible or ultraviolet portions of the electromagnetic spectrum. In one embodiment, the pump source 104 may include a laser system configured to emit continuous wave (CW) laser radiation. For example, the pump source 104 may include one or more CW infrared laser sources. For example, in settings where the gas within the gas containment element 108 is or includes argon, the pump source 104 may include a CW laser (e.g., fiber laser or disc Yb laser) configured to emit radiation at 1069 nm. It is noted that this wavelength fits to a 1068 nm absorption line in argon and as such is particularly useful for pumping argon gas. It is noted herein that the above description of a CW laser is not limiting and any laser known in the art may be implemented in the context of the present invention.

In another embodiment, the pump source 104 may include one or more diode lasers. For example, the pump source 104 may include one or more diode lasers emitting radiation at a wavelength corresponding with any one or more absorption lines of the species of the gas contained within the gas containment element 108. In a general sense, a diode laser of pump source 104 may be selected for implementation such that the wavelength of the diode laser is tuned to any absorption line of any plasma (e.g., ionic transition line) or any absorption line of the plasma-producing gas (e.g., highly excited neutral transition line) known in the art. As such, the choice of a given diode laser (or set of diode lasers) will depend on the type of gas contained within the gas containment element 108 of system 100.

In another embodiment, the pump source 104 may include an ion laser. For example, the pump source 104 may include any noble gas ion laser known in the art. For instance, in the case of an argon-based plasma, the pump source 104 used to pump argon ions may include an Ar+ laser.

In another embodiment, the pump source 104 may include one or more frequency converted laser systems. For example, the pump source 104 may include a Nd:YAG or Nd:YLF laser having a power level exceeding 100 watts. In another embodiment, the pump source 104 may include a broadband laser. In another embodiment, the pump source 104 may include a laser system configured to emit modulated laser radiation or pulsed laser radiation.

In another embodiment, the pump source 104 may include one or more lasers configured to provide laser light at substantially a constant power to the plasma 107. In another embodiment, the pump source 104 may include one or more modulated lasers configured to provide modulated laser light to the plasma 107. In another embodiment, the pump source 104 may include one or more pulsed lasers configured to provide pulsed laser light to the plasma 107.

In another embodiment, the pump source 104 may include one or more non-laser sources. In a general sense, the pump source 104 may include any non-laser light source known in the art. For instance, the pump source 104 may include any non-laser system known in the art capable of emitting radiation discretely or continuously in the infrared, visible or ultraviolet portions of the electromagnetic spectrum.

In another embodiment, the pump source 104 may include two or more light sources. In one embodiment, the pump source 104 may include two or more lasers. For example, the pump source 104 (or "sources") may include multiple diode lasers. By way of another example, the pump source 104 may include multiple CW lasers. In another embodiment, each of the two or more lasers may emit laser radiation tuned to a different absorption line of the gas or plasma within the gas containment element 108 of system 100. In this regard, the multiple pulse sources may provide illumination of different wavelengths to the gas within the gas containment element 108.

FIG. 1A illustrates the system 100, in accordance with an additional embodiment of the present disclosure. In one embodiment, the LSP illumination sub-system 102 includes a set of illumination optics 109 configured to transmit illumination 121 from the pump source 104 to an entrance window 124 of the gas containment element 108. In another embodiment, the collector 106 may then collect the pumping illumination 121 and focus it into the gas in order generate a plasma 107. The plasma 107, in turn, emits broadband radiation 107 (e.g., VUV, DUV or UV light), which is collected by the collector 106 and directed to optical element 105. In one embodiment, the optical element 105 includes any optical element suitable for separating the pump illumination 121 and the collected broadband radiation 133. Various types of optical configurations suitable for separating pump illumination 121 and the collected broadband radiation 133 are described in detail further herein. It is contemplated that each of the approaches for pump/broadband light separation described in the present disclosure is extendable to system 100. In another embodiment, optical element 105 may direct the broadband output 133 to one or more downstream optical elements 119 of the illumination sub-system 112 of the imaging sub-system 111 (i.e., inspection sub-system or inspector). It is noted herein that the illumination sub-system 112 may include a reflective based optical system, a refractive based optical system or a catadioptric optical system. In another embodiment, the illumination sub-system 112 may include a pupil assembly 132 located within the illumination pathway 113. In another embodiment, after the illumination 133 is transmitted through the illumination pupil assembly 132, the beam splitter 125 directs the illumination 133 onto the surface of the sample (e.g., wafer) disposed on the stage assembly 120. Further, the objective 114 may collect illumination 115 that is scattered, reflected or otherwise directed from the surface of the sample 116. Then, the objective 114 may focus the collected illumination 138 and direct the focused illumination to the detector 118 for imaging. In another embodiment, the focused illumination 138 is transmitted through collection pupil assembly 136 positioned along the collection pathway 117.

FIG. 1A also illustrates a barrier 140 that is located above the sample 116 and below the objective 114. As can be seen in FIG. 1A, the objective 114 constitutes the last sub-system component in the optical path from the light source 102 to the sample 116. In this embodiment, the barrier 140 has a larger surface area and/or diameter than that of the sample 116. In one embodiment, the barrier 140 is held or carried by a barrier holder 150. The barrier holder 150 can be mounted to or connected with any portion of the system 100, as long as it can position the barrier 140 in the desired region in the optical path. In one embodiment, the barrier holder 150 is fixedly connected to the barrier 140. In another embodiment, as illustrated, the barrier holder 150 comprises a releasable barrier holder. For example, in one embodiment, the barrier holder comprises a releasable clamp, that have clamp members 160 that engage exterior peripheral portions of the barrier 140 so as to not interfere with the radiation path. The barrier 140 can be securely held by the barrier holder 150 by closing the opposing clamp members 160 of the barrier holder 150 onto the periphery of the barrier and can be released from the barrier holder 150 (and replaced by another barrier 140) by releasing the clamp members. 160 and removing the barrier from the barrier holder 160 and from the system 100. In another embodiment, rather than a clamp, the barrier holder 150 may comprise releasable barrier holder by simply providing a slot 170 for slidably receiving the edges of,the barrier 140. Alternatively, the clamp members 160 and slot 170 can be used together, as seen in FIG. 1A. Specifically, in one embodiment, the clamp members 160 provide a slot such that the clamp members apply a minimal force (or no force) on the periphery of the barrier 140, without requiring the clamp members to be separated from one another to release the barrier 140 (which can be removed by simply sliding out from the slot). In another embodiment, the slot 170 is provided in a fixed structure, without the use of clamp members that can be moved or separated (not illustrated in the figures). The barrier 140 can be removed from the slot and replaced by another barrier 140 if the barrier becomes contaminated or worn.

FIG. 1B illustrates a bottom view of the barrier 140 and the sample 116. The barrier 140 covers the entire top surface of the sample 116. FIG. 1B illustrates the shape of the barrier 140 as circular, but it can alternatively be of a square shape, a rectangular shape, or any other shape.

FIG. 1C illustrates a side view of the barrier 140 and the sample 116. The barrier 140 is positioned directly above the sample 116, and the barrier 140 is separated from the sample 116 by 0.1mm to 10mm. Further, the barrier 140 has a larger surface area and diameter (or outer dimension) than that of the sample 116.

The barrier 140 can be applied to inhibit the passage of different types of impurities therethrough while allowing illumination to pass through. The term "inhibit" as used herein can be understood to mean to entirely prevent, and/or to effectively reduce impurities.

In one embodiment, the barrier 140 can be utilized to separate gas environments. The separation of environments may be desired for multiple reasons, such as prevention of outgassing from the sample 116 to the light source 102 and the components of the imaging sub-system 111 or the prevention of volatile contaminants from the inspection tool itself to reach the sample 116 under inspection. The volatile contaminants include gas impurities that solidify when they contact the sample. For example, SiH4 is gaseous but can solidify as SiO₂ on metal surfaces. Additionally, CH₄ can create long-chain hydrocarbons on the sample. The unwanted gasses or volatile contaminants are a type of "impurity" as that term is used herein.

In another embodiment, the barrier 140 can be used as a particle filter by inhibiting particles and contaminants from reaching different components of the inspection tool 100, such as the sample 116 or the imaging sub-system 111. Such particles or particulates are also a type of "impurity" as that term is used herein.

In another embodiment, the barrier 140 can be applied as a spectral purity filter (SPF) to improve the inspection performance of the tool itself by removing detrimental or parasitic wavelength intensities. The parasitic wavelength range are not limited to the VUV range. For example, removal of IR radiation (a byproduct of the VUV source) to prevent wafer heating can be targeted by an SPF. Further, a spectral purity filter enhances the stability of a signal and cleans the illumination spectrum to remove wavelengths outside the desired range. The barrier 140 for the spectral purity filter can be located anywhere along the optical path prior to the sample 116. The unwanted wavelengths or spectral impurities are another type of "impurity" as that term is used herein.

The barrier 140 can be configured to inhibit transmission of one or more of the types of impurities of the types mentioned above.

In one embodiment, the barrier 140 comprises a thin-film material. Though the thin film can be a single layer stack, in another embodiment it can comprise multiple layers. In various embodiments, each of the different layers may function to inhibit transmission of one or more respective impurities. For example, a Ru-coated carbon film could be used for gas separation and infrared illumination suppression. The barrier 140 can also be made of composite materials. Due to the nature of VUV light, which is readily absorbed by most materials, the described films are expected to be limited in thickness from 3nm to 200 nm. The lower limit is set by the robustness of the thin film whereas the upper limit follows from throughput considerations. For example, the transmission of a 40nm-thick carbon-film at a wavelength of 200nm is about 40%. The chemical composition of the film may consist of amorphous carbon, graphitic carbon, graphene, a network of carbon nanotubes, a network of boron nitride nanotubes, molybdenum, ruthenium, zirconium, tungsten, hafnium, boron, silicon, a mixture of molybdenum silicide/oxide/carbide/boride, a mixture of ruthenium silicide/oxide/carbide/boride, a mixture of zirconium silicide/oxide/carbide/boride, a mixture of tungsten silicide/oxide/carbide/boride, a mixture of hafnium silicide/oxide/carbide/boride, and a mixture of silicon oxide/carbide/nitride.

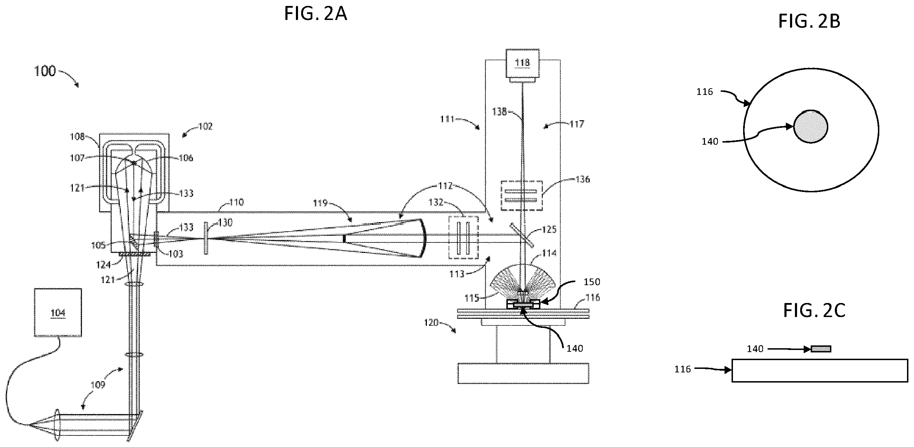

FIG. 2A illustrates the system 100, in accordance with an additional embodiment of the present disclosure. It is noted herein that the various embodiments and components described previously herein with respect to FIG. 1A should be interpreted to extend to FIG. 2A and are not repeated for purposes of clarity. FIG. 2A illustrates a barrier 140 that is located above the sample 116 and below the objective 114. The barrier 140 has a surface area that is smaller than the sample 116 surface area. The barrier 140 is connected to a barrier holder 150 that is attached to the objective 114. The barrier holder 150 has clamps around the exterior of the barrier 140. The barrier 140 can be inserted in the barrier holder 150 by opening the clamps of the barrier holder 150, or by sliding the barrier 140 into the opening of the barrier holder 150, or by another insertion method.

FIG. 2B illustrates a top view of the barrier 140 and the sample 116. The barrier 140 covers a portion of the top surface of the sample 116, and not the entirety thereof. FIG. 2B illustrates the shape of the barrier 140 as circular, but it can alternatively be of a square shape, a rectangular shape, or any other shape.

FIG. 2C illustrates a side view of the barrier 140 and the sample 116. The barrier 140 is positioned directly above the sample 116, and the barrier 140 is separated from the sample 116. Further, the barrier 140 has a smaller surface area than that of the sample 116.

The barrier 140 in FIGS. 2A-2C inhibit contamination of the sample 116 and allow for gas separation of the sample 116 and the system 100. This barrier 140 can be used as a particle filter to inhibit contaminants in the system 100 from reaching the sample. Additionally or alternatively, this barrier 140 can be used for gas separation of the chambers of the sample 116 and the system 100. As a result, gas from one chamber is inhibited from reaching another chamber. By separating the gas environments of each chamber, both the sample 116 and components of the inspection tool 100 are protected from outgassing and contamination.

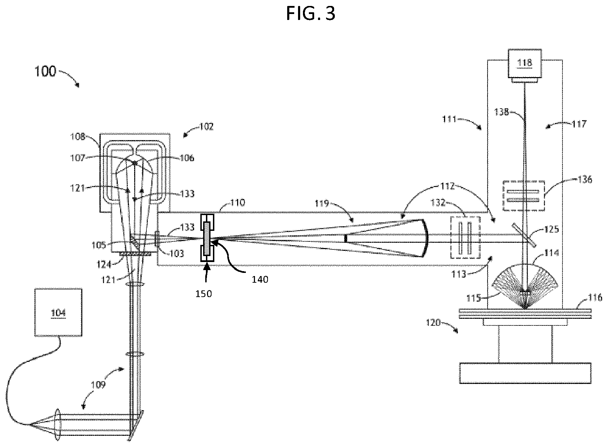

FIG. 3 illustrates the system 100, in accordance with an additional embodiment of the present disclosure. It is noted herein that the various embodiments and components described previously herein with respect to FIG. 1A should be interpreted to extend to FIG. 3 and are not repeated for purposes of clarity. FIG. 3 illustrates a barrier 140 that is positioned in the optical path of the imaging sub-system 111. The barrier 140 can be positioned at any number of positions within the imaging sub-system 111. One possible position is near the intermediate focus. The barrier 140 is connected to a barrier holder 150. The barrier holder 150 has clamps around the exterior of the barrier 140. The barrier 140 can be inserted in the barrier holder 150 by opening the clamps of the barrier holder 150, or by sliding the barrier 140 into the opening of the barrier holder 150, or by another insertion method.

The barrier 140 in FIG. 3 inhibits impurities in the light source 102 from reaching the components of the imaging sub-system 111. The light source 102 creates impurities detrimental to the rest of the inspection tool 100. As a result, positioning the barrier 140 at the entrance to the imaging sub-system 111 inhibits impurities from reaching optics and components of the imaging sub-system 111.

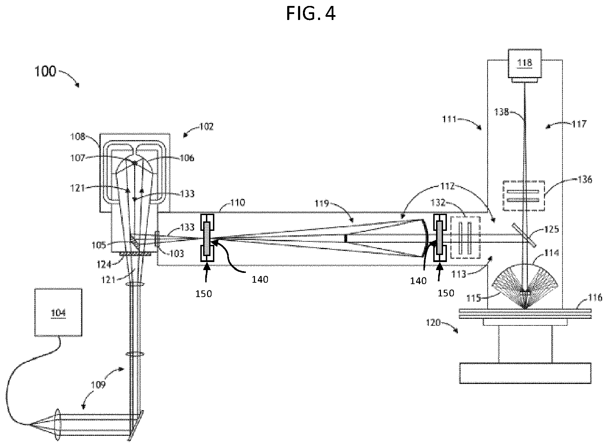

FIG. 4 illustrates the system 100, in accordance with an additional embodiment of the present disclosure. It is noted herein that the various embodiments and components described previously herein with respect to FIG. 1A should be interpreted to extend to FIG. 4 and are not repeated for purposes of clarity. FIG. 4 illustrates multiple barriers 140 that are positioned in the optical path of the imaging sub-system 111. The barriers 140 can be positioned at any number of positions within the imaging sub-system 111. The barriers 140 are connected to barrier holders 150. The barrier holders 150 have clamps around the exterior of the barriers 140. The barriers 140 can be inserted in the barrier holders 150 by opening the clamps of the barrier holders 150, or by sliding the barriers 140 into the opening of the barrier holders 150, or by another insertion method.

The multiple barriers 140 in FIG. 4 can have different functions, such as one spectral purity filter and one gas separation filter, or they can be identical barrier. The multiple barriers can create multiple gas environments. This can be done to, for example, place crucial optical components in a dedicated environment for defectivity or accuracy reasons. Similar to the previous embodiments, the barriers 140 act to protect the components of the imaging sub-system 111 from the light source 102 impurities as well as to separate the components of the imaging sub-system 111 into distinct gas environments.

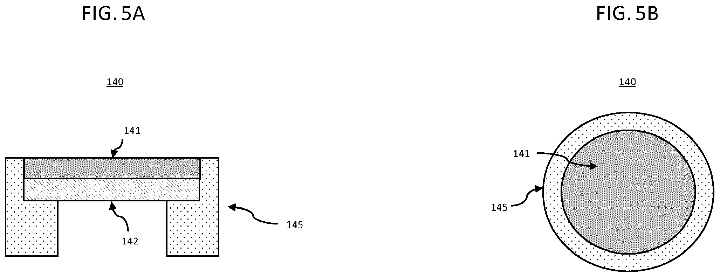

FIG. 5A illustrates a side view of the barrier 140. The barrier 140 comprises a thin film having multiple layers with a first layer 141 of a first material or composition of materials and a second layer 142 of a second material or composition of materials. Further, the barrier 140 comprises a frame 145 that is attached to the barrier 140. The frame 145 surrounds the perimeter of the barrier 140 and supports the barrier 140.

FIG. 5B illustrates a top view of the barrier 140. The first layer 141 of the barrier 140 (as well as the second layer 142) is held in place by the frame 145, which surrounds the first layer 141.

FIG. 5B illustrates the shape of the barrier 140 and frame 145 as circular, but they can alternatively be of a square shape, a rectangular shape, or any other shape.

For production of thin-film barrier, the "back-etch" method is used. A silicon wafer of 1-8 inch size is utilized, depending on the membrane dimensions. An etch stop layer is deposited on top of the silicon wafer, which is achieved by silicon oxide grown thermally or deposited through PVD / CVD. The main property of the etch stop layer is to stop the wet chemical etch which etches the wafer in a later process step. The etch selectivity of the etch stop layer should thus be significantly higher than for the silicon wafer, depending on what etchant is used (normally KOH or TMAH). On top of the etch stop layer, the function film layer(s) is deposited, which is done through thin film deposition methods such as PVD, CVD or ALD. Thereafter, a protective layer for possible anneal treatment and/or to protect the functional film material is grown during further processing. This processing may consist of lithography steps (patterning to determine the film dimensions or functionalization of optical properties, e.g., create a gridlike structure). The functional film is then made free-standing by etching away the silicon wafer from the backside using a hard mask, normally with KOH or TMAH. The protective etch stop layers are subsequently etched away as well. If these etch stop layers consist of silicon oxide, this etchant is normally BOE or HF.

In an embodiment, a sample inspection tool (100) comprises a light source (102) configured to produce effective inspection radiation below 200nm and greater than 100nm, a sample holder (120), an imaging sub-system (111) containing sub-system components (103, 130, 119, 132, 125, 114, 136, 118) that delivers light along an optical path from the light source to a sample (116) to be held by the sample holder, and a barrier (140) positioned between the last sub-system component (114) in the optical path and the sample to be held by the sample holder.

The barrier permits the radiation to pass therethrough while inhibiting impurities from reaching the sample to be held by the sample holder. The impurities comprise particulates, spectral impurities, and/or a particular gas or gasses in the inspection tool. As a result, the barrier protects the sample and/or sub-system components from impurities.

As for the structure of the barrier, it comprises a thin film having multiple layers, wherein a first layer (141) is made of a first material or composition of materials and a second layer (142) is made of a second material or composition of materials. The barrier comprises a thin film of carbon-containing material or a thin film of silicon-containing material. Further, the barrier comprises a frame (145) surrounding a thin film, and wherein the thin film has a thickness between 3nm and 200nm. Additionally, a releasable barrier holder (150) configured to hold the barrier at the position between the last optical element in the optical path and the sample to be held by the sample holder, the barrier holder configured to release the barrier to permit replacement thereof. Further, the barrier is separated from the sample by 0.1mm to 10mm.

In another embodiment, a sample inspection tool (100) comprises a light source (102) configured to produce effective inspection radiation below 200nm and greater than 100nm, a sample holder (120), an imaging sub-system (111) comprising sub-system components (103, 130, 119, 132, 125, 114, 136, 118) that delivers light along an optical path from the light source to a sample (116) to be held by the sample holder, and a barrier (140) positioned in the optical path prior to the last subsystem component (114) within the optical path.

The barrier inhibits impurities from reaching at least one sub-system component within the optical path, wherein the impurities comprise particulates and/or a particular gas or gasses in the inspection tool. As a result, the barrier protects the sample and/or sub-system components from impurities.

As for the structure of the barrier, it comprises a thin film having multiple layers, wherein a first layer (141) is made of a first material or composition of materials and a second layer (142) is made of a second material or composition of materials. The barrier comprises a thin film of carbon-containing material or a thin film of silicon-containing material. Further, the barrier comprises a frame (145) surrounding a thin film, and wherein the thin film has a thickness between 3nm and 200nm. Additionally, a releasable barrier holder (150) configured to hold the barrier at the position in the optical path prior to the last optical element within the optical path, the barrier holder configured to release the barrier to permit replacement thereof.

In another embodiment, a sample inspection tool (100) comprises a light source (102) configured to produce effective inspection radiation below 200nm and greater than 100nm, a sample holder (120), an imaging sub-system (111) containing sub-system components (103, 130, 119, 132, 125, 114, 136, 118) that that delivers light along an optical path from the light source to a sample (116) to be held by the sample holder, and a plurality of barriers (140) positioned within the optical path.

The plurality of barriers inhibits impurities from reaching the sub-system components and the sample to be held by the sample holder. The impurities comprise particulates, spectral impurities, and/or a particular gas or gasses in the inspection tool. As a result, the plurality of barriers protect the sample and/or sub-system components from impurities.

As for the structure of the barrier, it comprises a thin film having multiple layers, wherein a first layer (141) is made of a first material or composition of materials and a second layer (142) is made of a second material or composition of materials. Further, the barrier comprises a frame (145) surrounding a thin film, and wherein the thin film has a thickness between 3nm and 200nm. Additionally, a plurality of releasable barrier holders (150) configured to hold the plurality of barriers positioned within the optical path, the barrier holders configured to release the barriers to permit replacement thereof.

In yet another embodiment, a barrier (140) for use in an inspection tool (100) comprises a thin film having multiple layers, wherein a first layer (141) is made of a first material or composition of materials and a second layer (142) is made of a second material or composition of materials, different from the first material. The thin film comprises a carbon-containing material and having a thickness between 3nm and 200nm. Further, the barrier comprises a frame (145) surrounding the thin film, and wherein the barrier allows radiation to pass therethrough and inhibits impurities from passing therethrough. Additionally, the first layer inhibits particulate impurities from passing therethrough and the second layer inhibits spectral impurities from passing therethrough.

Further embodiments according to the current invention are described in below numbered clauses:
12. A sample inspection tool comprising:
   a light source configured to produce effective inspection radiation below 200nm; a sample holder;
   an imaging sub-system comprising sub-system components that deliver light along an optical path from the light source to a sample to be held by the sample holder; a barrier positioned in the optical path prior to the last sub-system component within the optical path, the barrier inhibiting impurities from reaching at least one sub-system component within the optical path, wherein the impurities comprise particulates.
13. The sample inspection tool of clause 12, wherein the impurities include a particular gas or gasses in the inspection tool.
14. The sample inspection tool of clause 12, wherein the barrier comprises a thin film having multiple layers, wherein a first layer is made of a first material or composition of materials and a second layer is made of a second material or composition of materials, different from the first material or composition of materials.
15. The sample inspection tool of clause 12, wherein the barrier comprises a thin film of carbon-containing material.
16. The sample inspection tool of clause 12, wherein the barrier comprises a thin film of silicon-containing material.
17. The sample inspection tool of clause 12, wherein the barrier comprises a frame surrounding a thin film, and wherein the thin film has a thickness between 3nm and 200nm.
18. The sample inspection tool of clause 12, further comprising a releasable barrier holder configured to hold the barrier at the position in the optical path prior to the last optical element within the optical path, the barrier holder configured to release the barrier to permit replacement thereof.
19. The sample inspection tool of clause 12, wherein the light source is configured to produce the effective inspection radiation of greater than 100nm.
20. A sample inspection tool comprising:
   a light source configured to produce effective inspection radiation below 200nm; a sample holder;
   an imaging sub-system containing sub-system components that that deliver light along an optical path from the light source to a sample to be held by the sample holder;
   a plurality of barriers positioned within the optical path, the plurality of barriers inhibiting impurities from reaching the sub-system components and the sample to be held by the sample holder.
21. The sample inspection tool of clause 20, wherein the impurities comprise particulates.
22. The sample inspection tool of clause 20, wherein the impurities comprise spectral impurities.
23. The sample inspection tool of clause 20, wherein the impurities include a particular gas or gasses in the inspection tool.
24. The sample inspection tool of clause 20, wherein the barrier comprises a thin film having multiple layers, wherein a first layer is made of a first material or composition of materials and a second layer is made of a second material or composition of materials, different from the first material or composition of materials.
25. The sample inspection tool of clause 20, wherein the barrier comprises a thin film of carbon-containing material.
26. The sample inspection tool of clause 20, wherein the barrier comprises a thin film of silicon-containing material.
27. The sample inspection tool of clause 20, wherein the barrier comprises a frame surrounding a thin film, and wherein the thin film has a thickness between 3nm and 200nm.
28. The sample inspection tool of clause 20, further comprising a plurality of releasable barrier holders configured to hold the plurality of barriers positioned within the optical path, the barrier holder configured to release the barrier to permit replacement thereof.
29. The sample inspection tool of clause 20, wherein the light source is configured to produce the effective inspection radiation of greater than 100nm.
30. A barrier for use in an inspection tool, the barrier comprising:
   a thin film having multiple layers, wherein a first layer is made of a first material or composition of materials and a second layer is made of a second material or composition of materials, different from the first material or composition of materials; wherein the thin film comprises a carbon containing material and having a thickness between 3nm and 200nm; wherein the barrier comprises a frame surrounding the thin film, and wherein the barrier allows radiation to pass therethrough and inhibits impurities from passing therethrough.
31. The barrier according to clause 29, wherein the first layer inhibits particulate impurities from passing therethrough and the second layer inhibits spectral impurities from passing therethrough.

The herein described subject matter sometimes illustrates different components contained within, or connected with, other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "connected," or "coupled," to each other to achieve the desired functionality, and any two components capable of being so associated can also be viewed as being "couplable," to each other to achieve the desired functionality. Specific examples of couplable include but are not limited to physically interactable and/or physically interacting components and/or wirelessly interactable and/or wirelessly interacting components and/or logically interactable and/or logically interacting components.

It is believed that the present disclosure and many of its attendant advantages will be understood by the foregoing description, and it will be apparent that various changes may be made in the form, construction and arrangement of the components without departing from the disclosed subject matter or without sacrificing all of its material advantages. The form described is merely explanatory, and it is the intention of the following claims to encompass and include such changes. Furthermore, it is to be understood that the invention is defined by the appended claims.

## Claims

1. A sample inspection tool comprising:
a light source configured to produce effective inspection radiation below 200nm;
a sample holder;
an imaging sub-system containing sub-system components that deliver light along an optical path from the light source to a sample to be held by the sample holder;
a barrier positioned between the last sub-system component in the optical path and the sample to be held by the sample holder, the barrier permitting the radiation to pass therethrough while inhibiting impurities from reaching the sample to be held by the sample holder.

2. The sample inspection tool of claim 1, wherein the impurities comprise particulates.

3. The sample inspection tool of claim 1, wherein the impurities comprise spectral impurities.

4. The sample inspection tool of claim 1, wherein the impurities include a particular gas or gasses in the inspection tool.

5. The sample inspection tool of claim 1, wherein the barrier comprises a thin film having multiple layers, wherein a first layer is made of a first material or composition of materials and a second layer is made of a second material or composition of materials, different from the first material or composition of materials.

6. The sample inspection tool of claim 1, wherein the barrier comprises a thin film of carbon-containing material.

7. The sample inspection tool of claim 1, wherein the barrier comprises a thin film of silicon-containing material.

8. The sample inspection tool of claim 1, wherein the barrier comprises a frame surrounding a thin film, and wherein the thin film has a thickness between 3nm and 200nm.

9. The sample inspection tool of claim 1, further comprising a releasable barrier holder configured to hold the barrier at the position between the last optical element in the optical path and the sample to be held by the sample holder, the barrier holder configured to release the barrier to permit replacement thereof.

10. The sample inspection tool of claim 1, wherein the light source is configured to produce the effective inspection radiation of greater than 100nm.

11. The sample inspection tool of claim 1, wherein the barrier is separated from the sample by 0.1mm to 10mm.
